# EUROPEAN PATENT APPLICATION

(11) **EP 2 312 617 A1**
(43) Date of publication of application: **20.04.2011**
(21) Application number: 09773427.1
(22) Date of filing: 29.06.2009
(51) Int. Cl.: H01L 21/205, C23C 16/448, H01L 21/31

(54) **VACUUM PROCESSING DEVICE AND GAS SUPPLY METHOD**

(30) Priority: 04.07.2008 JP 2008176045
(71) Applicant: Sharp Kabushiki Kaisha, Osaka-shi, Osaka 545-8522 (JP)
(72) Inventor: KISHIMOTO, Katsushi, Osaka 545-8522 (JP); NISHI, Yutaka, Osaka 545-8522 (JP)
(74) Representative: Müller - Hoffmann & Partner
(86) International application number: PCT/JP2009/061834
(87) International publication number: WO 2010/001849

(57) **Abstract**

In a vacuum treatment apparatus according to an embodiment of the present invention, a control means performs, when treatment in a vacuum vessel using a flammable gas (step S2) ends, a step of closing a first valve and performing evacuation (step S3), a step of closing a second valve (step S4) after the evacuation, and a step of opening a fifth valve to supply an inert gas in a third vessel to a first supply line (step S5), and, when treatment in the vacuum vessel using a combustion-supporting gas (step S8) ends, a step of closing a third valve and performing evacuation (step S9), a step of closing a fourth valve (step S10) after the evacuation, and a step of opening a sixth valve to supply an inert gas in a fourth vessel to a second supply line (step 811).

## Description

### Technical Field

The present invention relates to vacuum treatment apparatuses used in membrane formation, etching, or other production processes of various electronic devices, and gas supply methods for the vacuum treatment apparatuses, and more specifically relates to gas supply methods for vacuum treatment apparatuses that use a flammable gas and a combustion-supporting gas in a switchable manner.

### Background Art

In a vacuum treatment apparatus that uses a flammable gas and a combustion-supporting gas in a switchable manner, if the flammable gas and the combustion-supporting gas are accidentally mixed with each other, they rapidly react with each other to cause a great danger, and, thus, supply lines of these gases have to be reliably blocked from each other.

Accordingly, the configuration of a conventional vacuum treatment apparatus is devised so as to improve block performance by arranging two valves on each of the flammable gas supply line and the combustion-supporting gas supply line.

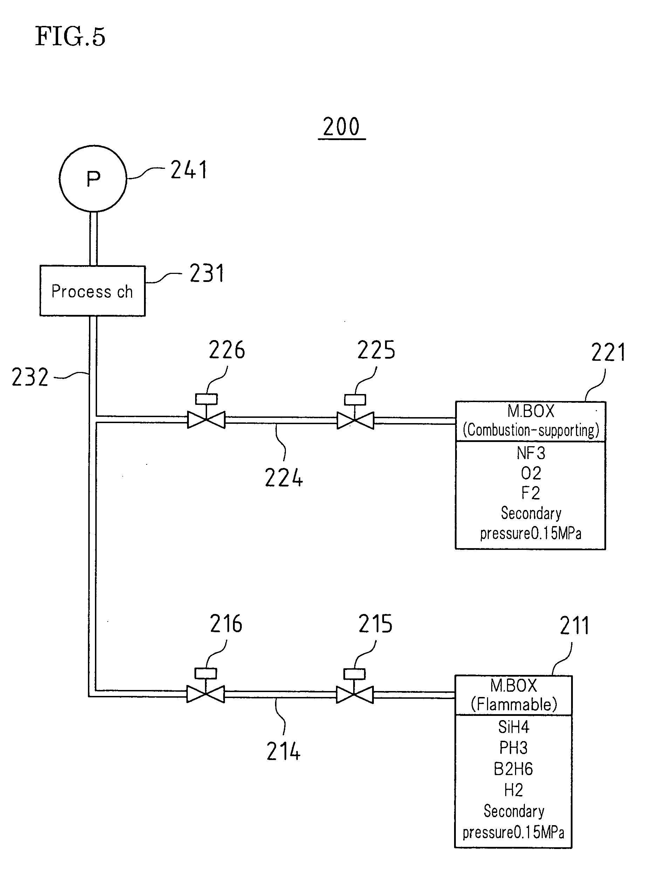

FIG. 5 shows the schematic configuration of such a conventional vacuum treatment apparatus.

Broadly speaking, a vacuum treatment apparatus 200 is provided with a first gas supply portion 211 that is filled with a flammable gas, a second gas supply portion 221 that is filled with a combustion-supporting gas, a vacuum vessel (chamber) 231 that performs treatment using either the flammable gas or the combustion-supporting gas introduced from a common line 232, and a vacuum discharge pump 241 that discharges the gas in the vacuum vessel 231.

Further provided are a first supply line 214 that supplies the flammable gas from the first gas supply portion 211 via the common line 232 to the vacuum vessel 231 and a second supply line 224 that supplies the combustion-supporting gas from the second gas supply portion 221 via the common line 232 to the vacuum vessel 231. The first supply line 214 is provided with a first valve 215 near the first gas supply portion 211 and a second valve 216 near the common line 232 (i.e., near the portion linking the first supply line 214 and the second supply line 224). Furthermore, the second supply line 224 is provided with a third valve 225 near the second gas supply portion 221 and a fourth valve 226 near the common line 232 (i.e., near the portion linking the first supply line 214 and the second supply line 224). This configuration is referred to as Conventional Technique 1.

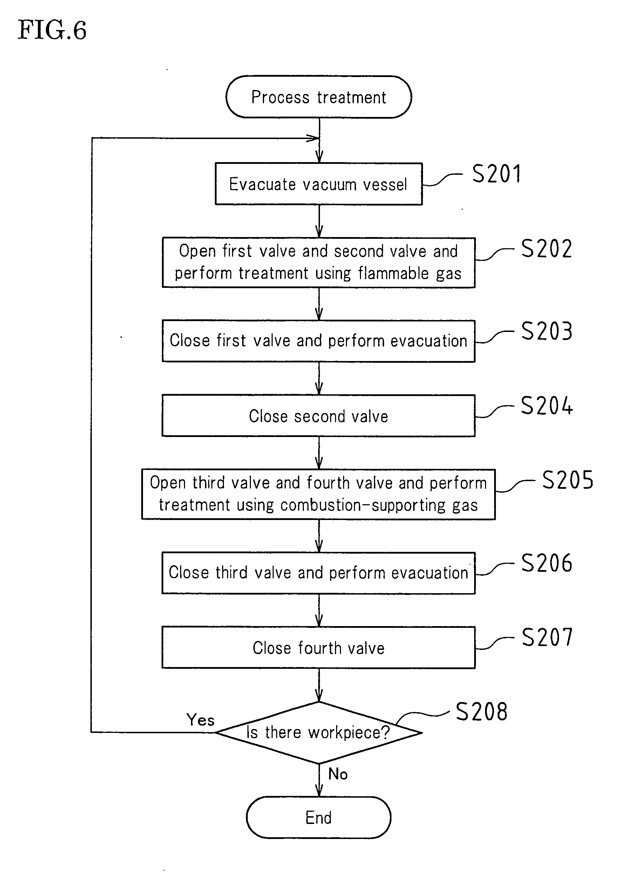

The vacuum treatment apparatus 200 having such a configuration performs opening and closing control of the valves in the following manner in vacuum treatment (process treatment) of a workpiece. Hereinafter, the opening and closing control of the valves will be described with reference to a flowchart shown in FIG. 6.

First, after a workpiece is placed and sealed in the vacuum vessel 231, the vacuum vessel 231 is evacuated in a state where all the valves 215, 216, 225, and 226 are closed (step S201).

Subsequently, the flammable gas is supplied from the first gas supply portion 211, the first valve 215 and the second valve 216 are opened to introduce the flammable gas into the vacuum vessel 231, and the workpiece is treated in the vacuum vessel 231 using the flammable gas (step S202).

When the treatment in the vacuum vessel 231 using the flammable gas ends in this state, the flammable gas supply from the first gas supply portion 211 is stopped, and, then, the first valve 215 is closed, and evacuation is performed (step S203).

When the evacuation ends, the second valve 216 is closed (step 5204). That is to say, the first supply line 214 between the first valve 215 and the second valve 216 at that time is in a vacuum state.

In this state, the combustion-supporting gas is supplied from the second gas supply portion 221, and, then, the third valve 225 and the fourth valve 226 are opened, and treatment in the vacuum vessel 231 using the combustion-supporting gas is started (step S205).

Subsequently, when the treatment in the vacuum vessel 231 using the combustion-supporting gas ends, the combustion-supporting gas supply from the second gas supply portion 221 is stopped, and, then, the third valve 225 is closed, and evacuation is performed (step S206).

When the evacuation ends, the fourth valve 226 is closed (step S207). That is to say, the second supply line 224 between the third valve 225 and the fourth valve 226 at that time is in a vacuum state.

Subsequently, if a next workpiece is successively treated (if judged Yes in step S208), the procedure returns to step S201 and the above-described processes are repeated.

In the conventional vacuum treatment apparatus 200 that performs such opening and closing control of the valves, for example, when the treatment using the flammable gas is performed, the first supply line 214 and the common line 232 are filled with the flammable gas, and the flammable gas is filled in the second supply line 224 up to the downstream side (the vacuum vessel 231 side) of the fourth valve 226. Then, if a leak occurs at the fourth valve 226 in this state, since the portion between the fourth valve 226 and the third valve 225 is in a vacuum state at that time as described above, the flammable gas filled in the line up to the downstream side of the fourth valve 226 is drawn by the vacuum to flow into the upstream side (the second gas supply portion 221 side) of the fourth valve 226, and the portion between the fourth valve 226 and the third valve 225 is filled with the flammable gas.

In the conventional vacuum treatment apparatus 200, two valves are arranged on each of the supply lines, and, thus, the combustion-supporting gas and the flammable gas are not mixed with each other in this state. However, if a further leak occurs at the third valve 225 in this state, a problem occurs in which the flammable gas on the downstream side of the third valve 225 and the combustion-supporting gas on the upstream side are mixed with each other to cause a great danger. Furthermore, a problem occurs in which a gas may flow from the outside into the supply lines because the supply lines not in use are in a vacuum state.

A vacuum treatment apparatus devised for preventing the combustion-supporting gas and the flammable gas from being mixed with each other is conventionally proposed (see Patent Literature 1, for example).

FIG. 7 shows the schematic configuration of the vacuum treatment apparatus described in Patent Literature 1.

This vacuum treatment apparatus is a vacuum treatment apparatus using plasma CVD shown in FIG. 11 of Patent Literature 1, and is configured from a vacuum treatment furnace 50 and an external starting material gas supply apparatus 100 that supplies a predetermined starting material gas via a pipe 132. Here, the vacuum treatment furnace 50 is simplified in the drawing. Hereinafter, the configuration of the vacuum treatment apparatus (mainly the configuration of the starting material gas supply apparatus 100) will be described with reference to the description in Patent Literature 1.

The starting material gas supply apparatus 100 is configured from a plurality of cylinders 101 to 104 that are filled with desired starting material gases, pressure adjusters 105 to 108, valves 109 to 112, mass flow controllers 113 to 116, and valves 117 to 128. After the starting material gases supplied from the cylinders 101 to 104 are respectively sent to the pressure adjusters 105 to 108 where their pressures are reduced to appropriate ones and then to the valves 109 to 112 and the mass flow controllers 113 to 116 where their flow rates are adjusted to desired ones, the gases are sent via the valves 121 to 124 to the pipe 132, and are then supplied via the pipe 132 to the vacuum treatment furnace 50.

The pipes via which the starting material gases flow into the mass flow controllers 113 to 116 are each branched, and these branched pipes respectively function as pipes via which the starting material gases flow into the valves 117 to 120. The pipes via which the starting material gases flow out of the valves 117 to 120 are each branched, where first branched pipes are respectively linked to the pipes via which the starting material gases flow out of the mass flow controllers 113 to 116, and second branched pipes respectively function as pipes via which the starting material gases flow into the valves 125 to 128. The pipes via which the starting material gases flow out of the valves 125 to 128 are linked to a discharge pipe 133 functioning as a discharge route of the starting material gas supply apparatus 100, and the discharge pipe 133 is connected via a valve 129 to a vacuum pump 130.

In the thus configured vacuum treatment apparatus, a slow introduction process is performed in the following manner. In Patent Literature 1, assuming that the cylinder 101 is filled with a flammable gas and the cylinder 102 is filled with a combustion-supporting gas, an operation that switches discharges of the gases is described. Hereinafter, the slow introduction process will be described with reference to the description in Patent Literature 1. FIG. 8 is a flowchart illustrating the procedure of the slow introduction process, and is a flowchart shown in FIG. 1 of Patent Literature 1.

If a slow introduction command is input to a control apparatus (not shown) (step S301), the control apparatus determines whether or not a slow introduction command on the flammable gas is contained in the input slow introduction command (step S302). If a slow introduction command on the flammable gas is contained, the control apparatus opens the valves 125, 117, and 129 to start flammable gas discharge (step S303), and starts a timer (not shown) to count the flammable gas discharge time. If a slow introduction command on the flammable gas is not contained in the slow introduction command, the procedure advances to a process in step S307 (described later).

If a time set in advance has elapsed after starting the flammable gas discharge (step S304), the control apparatus closes the valves 125 and 117 to end the flammable gas discharge (step S305). After the flammable gas discharge ends, the control apparatus once sets the flow rate at the mass flow controller 113 to 0 ml/min (normal), and then opens the valves 121 and 109 to supply the flammable gas while performing control such that the flow rate at the mass flow controller 113 is a designated flow rate (step S306).

With the above-described operation, the flammable gas filled in the cylinder 101 is supplied to the vacuum treatment apparatus.

After the flammable gas introduction ends, the control apparatus determines whether or not a slow introduction command on the combustion-supporting gas is contained in the slow introduction command input in step S301 (step S307). If a slow introduction command on the combustion-supporting gas is contained, the control apparatus opens the valves 126 and 118 to start combustion-supporting gas discharge (step S308), and starts a timer (not shown) to count the combustion-supporting gas discharge time. If a slow introduction command on the combustion-supporting gas is not contained in the slow introduction command, the procedure advances step S312 (described later) where the slow introduction process ends.

If a time set in advance has elapsed after starting the combustion-supporting gas discharge (step S309), the control apparatus closes the valves 126 and 118 to end the discharge (step S310). After the combustion-supporting gas discharge ends, the control apparatus once sets the flow rate at the mass flow controller 114 to 0 ml/min (normal), and then opens the valves 122 and 110 to supply the combustion-supporting gas while performing control such that the flow rate at the mass flow controller 114 is a designated flow rate (step S311).

With the above-described operation, the combustion-supporting gas filled in the cylinder 102 is supplied to the vacuum treatment apparatus. After the combustion-supporting gas supply, the slow introduction process ends (step S312).

### Citation List

### Patent Literature

Patent Literature 1: JP 2003-31507A

### Summary of Invention

### Problem to be Solved by the Invention

In the vacuum treatment apparatus of Conventional Technique 1 above, two valves are arranged on each of the supply lines, and, thus, even when a leak occurs at one of the valves, the flammable gas and the combustion-supporting gas are not mixed with each other in this state. However, if a further leak occurs at the other valve in this state, a problem occurs in which the flammable gas and the combustion-supporting gas are mixed with each other to cause a great danger. One reason for such a problem is that, even if two valves are arranged, the portion between the valves is kept in a vacuum state. Thus, when a leak occurs at one of the valves, a gas from the outside easily flows into the portion between the valves.

Furthermore, the vacuum treatment apparatus of Patent Literature 1 above is a vacuum treatment apparatus in which the flammable gas and the combustion-supporting gas are mixed in use. If such gases that react with each other are mixed to perform treatment, the partial pressures of the gases have to be at allowable values or less. Accordingly, in Patent Literature 1 above, the discharge apparatus 130 is provided and the slow introduction process is performed as described above, and, thus, a momentary increase in the flow rate at the time of starting gas introduction is prevented as shown in FIGS. 8 to 10 of Patent Literature 1. The reason for this is that, with such an increase in the flow rate, when the gases are mixed with each other, the partial pressure of a gas introduced later temporarily exceeds the allowable partial pressure, and the mixed gases react with each other.

However, in Patent Literature 1 above, it is not assumed that a failure occurs at each valve, or that a leak occurs even when a valve is closed. For example, in Patent Literature 1, when the combustion-supporting gas is supplied to the vacuum treatment apparatus after the flammable gas is supplied to the vacuum treatment apparatus, the portion of the valves 121 and 109 and the mass flow controller 113 is still filled with the flammable gas. Accordingly, if a leak (failure) occurs at the valve 121 in this state, the flammable gas flows into the pipe 132, and a problem occurs in which the flammable gas is mixed with the combustion-supporting gas at an allowable partial pressure or more.

The present invention was devised in order to solve these problems, and it is an object thereof to provide a vacuum treatment apparatus and a gas supply method that can reliably prevent a flammable gas and a combustion-supporting gas from being mixed with each other even when a leak (failure) occurs at a valve, by filling one of gas lines with an inert gas when using a gas from the other gas line, and that can simplify the apparatus configuration without requiring a discharge apparatus as in Patent Literature 1 above.

### Means for Solving the Problems

In order to solve the above-described problems, the present invention is directed to a vacuum treatment apparatus, including: a first gas supply portion that is filled with a flammable gas; a second gas supply portion that is filled with a combustion-supporting gas; a vacuum vessel that performs treatment using either the flammable gas or the combustion-supporting gas introduced from a common line; a first supply line that supplies the flammable gas from the first gas supply portion via the common line to the vacuum vessel; a second supply line that supplies the combustion-supporting gas from the second gas supply portion via the common line to the vacuum vessel; a first valve that is provided in the first supply line; a second valve that is provided in the first supply line at a position that is closer to the common line than the first valve is; a third valve that is provided in the second supply line; a fourth valve that is provided in the second supply line at a position that is closer to the common line than the third valve is; and a control means that controls an opening and closing operation of the valves; wherein a third gas supply portion that is filled with an inert gas is connected via a fifth valve to the first supply line between the first valve and the second valve, a fourth gas supply portion that is filled with an inert gas is connected via a sixth valve to the second supply line between the third valve and the fourth valve, and the control means fills the second supply line between the third valve and the fourth valve with the inert gas by supplying the inert gas from the fourth gas supply portion via the sixth valve before using the first supply line, and fills the first supply line between the first valve and the second valve with the inert gas by supplying the inert gas from the third gas supply portion via the fifth valve before using the second supply line.

In such a configuration, when the treatment in the vacuum vessel using the flammable gas ends, the control means performs a step of closing the first valve and performing evacuation, a step of closing the second valve after the evacuation, a step of opening the fifth valve to supply the inert gas in the third gas supply portion to the first supply line between the first valve and the second valve, and closing the fifth valve after supplying the inert gas. Accordingly, before the second supply line is used next time, the first supply line between the first valve and the second valve is kept filled with the inert gas.

Furthermore, when the treatment in the vacuum vessel using the combustion-supporting gas ends, the control means performs a step of closing the third valve and performing evacuation, a step of closing the fourth valve after the evacuation, a step of opening the sixth valve to supply the inert gas in the fourth gas supply portion to the second supply line between the third valve and the fourth valve, and closing the sixth valve after supplying the inert gas. Accordingly, before the first supply line is used next time, the second supply line between the third valve and the fourth valve is kept filled with the inert gas.

According to the present invention, when one of the gas supply lines is being used, the portion between the valves in the other gas supply line is filled with an inert gas, and, thus, the inert gas is interposed between the flammable gas and the combustion-supporting gas in the supply line. Accordingly, even when a leak occurs at the valve, the flammable gas and the combustion-supporting gas can be prevented from being directly mixed with each other. Furthermore, since, when one of the gas supply lines is being used, the portion between the valves in the other gas supply line not in use is filled with the inert gas, a gas can be prevented from flowing from the outside into the other gas supply line not in use.

In this case, it is preferable that the pressure of the inert gas filled in one of the supply lines between the valves is kept higher than the pressure of the gas in the other supply line in use. Accordingly, even when a leak occurs at a valve (the second valve or the fourth valve) disposed between the inert gas and the flammable gas or combustion-supporting gas, the gas in use does not flow into the inert gas although the inert gas may flow into the gas in use. Accordingly, even when a leak or the like occurs at the valve, the flammable gas and the combustion-supporting gas can be reliably blocked from each other.

Furthermore, the vacuum treatment apparatus according to the present invention may be configured such that the first supply line is provided with a first pressure detecting means that detects a pressure between the first valve and the second valve, the second supply line is provided with a second pressure detecting means that detects a pressure between the third valve and the fourth valve, and the control means stops vacuum treatment in a case where the pressure detecting means detects a pressure decrease in one of the supply lines while the other supply line is being used.

That is to say, in the case where the second pressure detecting means detects that the pressure between the third valve and the fourth valve in the second supply line (i.e., the pressure of the inert gas) decreases during the treatment in the vacuum vessel using the flammable gas, the control means performs a step of stopping the treatment in the vacuum vessel using the flammable gas. Furthermore, in the case where the first pressure detecting means detects that the pressure between the first valve and the second valve in the first supply line (i.e., the pressure of the inert gas) decreases during the treatment in the vacuum vessel using the combustion-supporting gas, the control means performs a step of stopping the treatment in the vacuum vessel using the combustion-supporting gas. If the treatment is stopped immediately after detecting occurrence of a leak at a valve in this manner, the apparatus can be reliably stopped before the combustion-supporting gas and the flammable gas are mixed with each other.

Furthermore, the vacuum treatment apparatus according to the present invention may be configured such that the first supply line is provided with a third pressure detecting means that detects a pressure between the first valve and the first gas supply portion, the second supply line is provided with a fourth pressure detecting means that detects a pressure between the third valve and the second gas supply portion, and the control means determines that a leak has occurred at the first valve in a case where the first pressure detecting means detects a pressure decrease and the third pressure means detects a pressure increase while the second supply line is being used, and determines that a leak has occurred at the third valve in a case where the second pressure detecting means detects a pressure decrease and the fourth pressure means detects a pressure increase while the first supply line is being used. Furthermore, the vacuum treatment apparatus may be configured such that the first supply line is provided with a fifth pressure detecting means that detects a pressure between the second valve and the common line, the second supply line is provided with a sixth pressure detecting means that detects a pressure between the fourth valve and the common line, and the control means determines that a leak has occurred at the second valve in a case where the first pressure detecting means detects a pressure decrease and the fifth pressure means detects a pressure increase while the second supply line is being used, and determines that a leak has occurred at the fourth valve in a case where the second pressure detecting means detects a pressure decrease and the sixth pressure means detects a pressure increase while the first supply line is being used. With such a configuration, when a leak occurs, a valve at which the leak has occurred can be immediately specified, and subsequent repair, maintenance, or other operations can be promptly performed.

### Effects of the Invention

According to the present invention, when one of gas supply lines is being used, the other gas supply line is filled with an inert gas, and, thus, a flammable gas and a combustion-supporting gas can be reliably prevented from being mixed with each other even when a leak occurs at a valve.

### Brief Description of Drawings

FIG. 1 is a schematic diagram showing a vacuum treatment apparatus according to Embodiment 1 of the present invention.
FIG. 2 is a schematic diagram of a first gas supply portion and a second gas supply portion.
FIG. 3 is a flowchart illustrating vacuum treatment (process treatment) of a workpiece by the vacuum treatment apparatus of the present invention.
FIG. 4 is a schematic diagram showing a vacuum treatment apparatus according to Embodiment 2 of the present invention.
FIG. 5 is a schematic diagram of a conventional vacuum treatment apparatus.
FIG. 6 is a flowchart illustrating vacuum treatment (process treatment) of a workpiece by the conventional vacuum treatment apparatus.

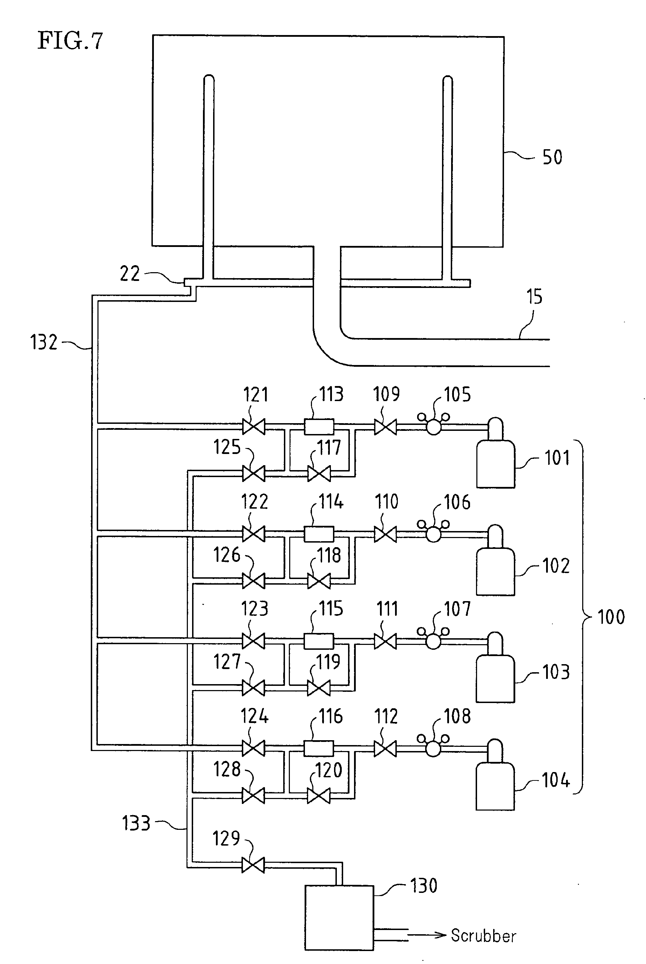

FIG. 7 is a schematic diagram of a vacuum treatment apparatus described in Patent Literature 1.

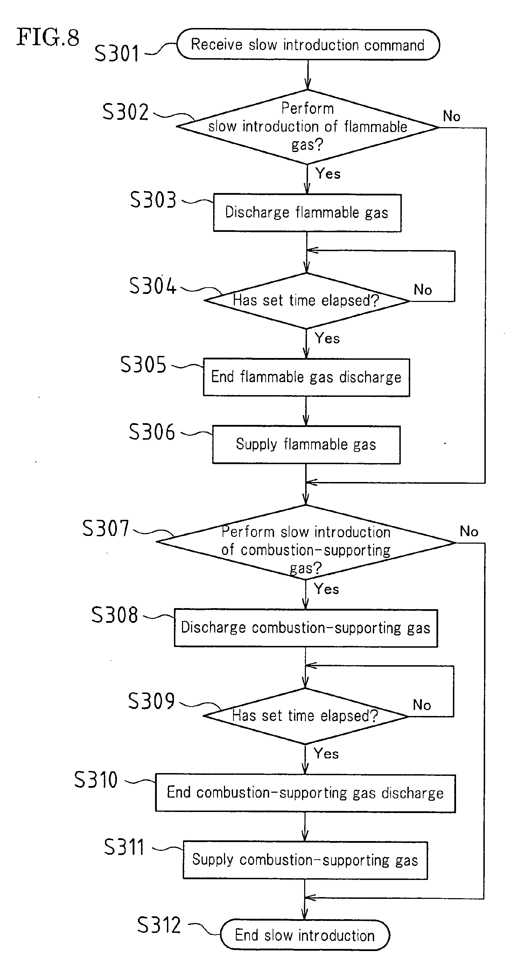

FIG. 8 is a flowchart illustrating vacuum treatment (process treatment) of a workpiece by the vacuum treatment apparatus described in

### Patent Literature 1.

### Description of Embodiments

Hereinafter, embodiments of the present invention will be described with reference to the drawings.

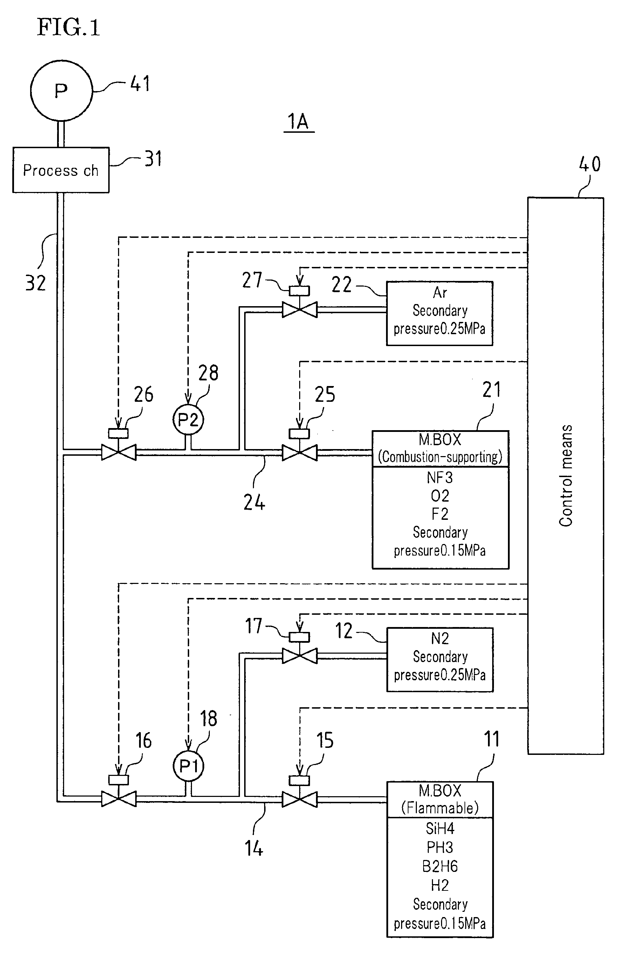

FIG. 1 is a schematic diagram showing a vacuum treatment apparatus according to Embodiment 1 of the present invention. Embodiment 1 describes, as an example, the case in which the present invention is applied to a plasma CVD apparatus that uses a flammable gas and a combustion-supporting gas in a switchable manner.

Broadly speaking, a vacuum treatment apparatus 1A is provided with a first gas supply portion 11 that is filled with a flammable gas, a second gas supply portion 21 that is filled with a combustion-supporting gas, a vacuum vessel (process chamber) 31 that performs treatment using either the flammable gas or the combustion-supporting gas introduced from a common line 32, a vacuum discharge pump 41 that discharges the gas in the vacuum vessel 31, and a third gas supply portion 12 and a fourth gas supply portion 22 that are filled with inert gases.

Further provided are a first supply line 14 that supplies the flammable gas from the first gas supply portion 11 via the common line 32 to the vacuum vessel 31 and a second supply line 24 that supplies the combustion-supporting gas from the second gas supply portion 21 via the common line 32 to the vacuum vessel 31. The first supply line 14 is provided with a first valve 15, and the first valve 15 is preferably disposed near (very close to) the first gas supply portion 11. The first supply line 14 is further provided with a second valve 16 at a position that is closer to the common line 32 than the first valve 15 is. The second valve 16 is preferably disposed near the common line 32 (i.e., near the portion linking the first supply line 14 and the second supply line 24). Furthermore, the second supply line 24 is provided with a third valve 25, and the third valve 25 is preferably disposed near (very close to) the second gas supply portion 21. The second supply line 24 is further provided with a fourth valve 26 at a position that is closer to the common line 32 than the third valve 25 is. The fourth valve 26 is preferably disposed near the common line 32 (i.e., near the portion linking the first supply line 14 and the second supply line 24).

Furthermore, the third gas supply portion 12 that is filled with the inert gas is connected via a fifth valve 17 to the first supply line 14 between the first valve 15 and the second valve 16, and the fourth gas supply portion 22 that is filled with the inert gas is connected via a sixth valve 27 to the second supply line 24 between the third valve 25 and the fourth valve 26.

Furthermore, a first pressure gauge (P1) 18 is connected to the first supply line 14 between the first valve 15 and the second valve 16, and a second pressure gauge (P2) 28 is connected to the second supply line 24 between the third valve 25 and the fourth valve 26.

Although simplified in the diagram, the valves 15 to 17 and 25 to 27 and the pressure gauges 18 and 28 are connected to a control means (e.g., a computer) 40 that controls the operation of the entire apparatus (in the drawing, the connection is indicated by dotted lines). The valves 15 to 17 and 25 to 27 are driven to be opened and closed by electromagnetic valves arranged corresponding to these valves, and opening and closing control of the electromagnetic valves is performed by the control means 40. Here, the second valve 16 and the fourth valve 26 are interlocked so as not to be simultaneously opened, that is, so as to be prohibited from being simultaneously opened.

Furthermore, detection signals (pressure values) of the pressure gauges 18 and 28 are input to the control means 40, and the control means 40 determines whether or not to stop a vacuum treatment operation based on the detection signals (pressure values) from the pressure gauges 18 and 28.

Here, examples of the flammable gas supplied from the first gas supply portion 11 include SiH₄, PH₃, B₂H₆, and H₂, and examples of the combustion-supporting gas supplied from the second gas supply portion 21 include NF₃, O₂, and F₂. Furthermore, examples of the inert gas supplied from the third gas supply portion 12 include N₂, and examples of the inert gas supplied from the fourth gas supply portion 22 include Ar. Here, Ar may be supplied from the third gas supply portion 12, and N₂ may be supplied from the fourth gas supply portion 22.

Furthermore, both the pressures of the flammable gas supplied from the first gas supply portion 11 and the combustion-supporting gas supplied from the second gas supply portion 21 are adjusted to 0.15 MPa, and both the pressures of the inert gases supplied from the third and the fourth gas supply portions 12 and 22 are adjusted to 0.25 MPa.

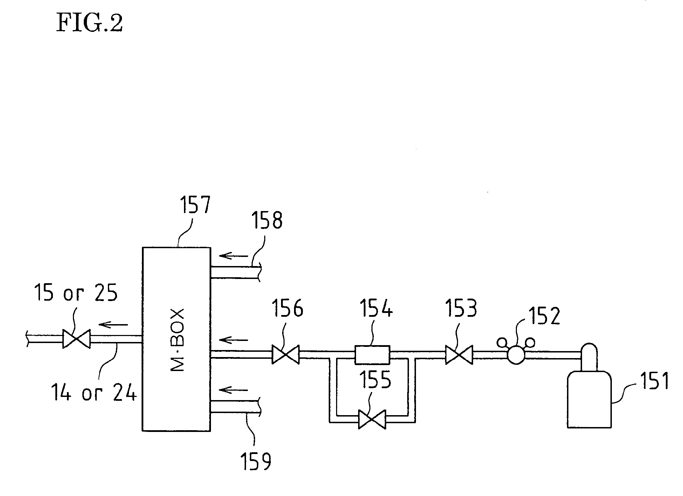

FIG. 2 shows the configuration of the first gas supply portion 11 and the second gas supply portion 21. That is to say, the gas supply portion is configured from a cylinder 151 that is filled with a desired starting material gas, a pressure adjuster 152, a valve 153, a mass flow controller 154, valves 155 and 156, and a mixing box 157. That is to say, the first gas supply portion 11 and the second gas supply portion 21 are configured so as to include the mixing box 157 in the case where a plurality of gases are mixed and supplied. After the starting material gas supplied from the cylinder 151 is sent to the pressure adjuster 152 where its pressure is reduced to an appropriate one and then to the valve 153 and the mass flow controller 154 where its flow rate is adjusted to a desired one, the gas is supplied via the valve 156 to the mixing box 157 where the gas is mixed with other gases supplied from other pipes 158 and 159 (the number of the other pipes in the first gas supply portion 11 is three, in this embodiment), and is then supplied to the first supply line 14 or the second supply line 24. Here, both the first gas supply portion 211 and the second gas supply portion 221 shown in FIG. 5 have the same configuration as that described above. Furthermore, the third gas supply portion 12 and the fourth gas supply portion 22 have a configuration obtained by eliminating the mixing box 157 from the configuration shown in FIG. 2, because these gas supply portions supply only one type of gas.

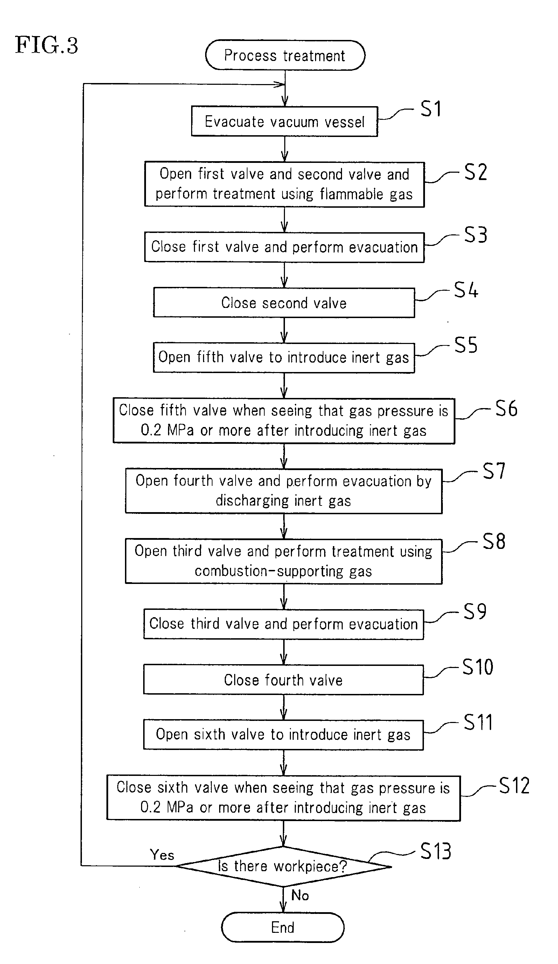

Next, the vacuum treatment (process treatment) of a workpiece by the thus configured vacuum treatment apparatus 1A will be described with reference to a flowchart shown in FIG. 3.

First, after a workpiece is placed in the vacuum vessel 31, the vacuum vessel 31 is evacuated in a state where all the valves 15, 16, 25, and 26 are closed (step S1).

Subsequently, the first valve 15 and the second valve 16 are opened to introduce the flammable gas into the vacuum vessel 31, and the workpiece is treated in the vacuum vessel 31 using the flammable gas (step S2).

When the treatment in the vacuum vessel 31 using the flammable gas ends in this state, the first valve 15 is closed, and evacuation is performed (step S3).

When the evacuation ends, the second valve 16 is closed (step S4), and, then, the fifth valve 17 is opened to introduce the inert gas in the third gas supply portion 12 into the first supply line 14 between the first valve 15 and the second valve 16 (step S5).

Next, when it is seen that the pressure value of the first pressure gauge 18 reaches, for example, 0.2 MPa or more, the fifth valve 17 is closed (step S6). Accordingly, the first supply line 14 between the first valve 15 and the second valve 16 is filled with the inert gas (N₂) at a pressure of 0.2 MPa or more.

Next, the fourth valve 26 is opened in this state, and the second supply line 24 is evacuated by discharging the inert gas therein (step S7). If a flushing operation that opens and closes the third valve 25 is also performed at that time, the inert gas in the second supply line 24 can be completely discharged.

Subsequently, the third valve 25 is opened to supply the combustion-supporting gas to the vacuum vessel 31, and treatment in the vacuum vessel 31 is started (step S8).

After the treatment in the vacuum vessel 31 using the combustion-supporting gas ends, the third valve 25 is closed, and evacuation is performed (step S9).

When the evacuation ends, the fourth valve 26 is closed (step S10), and, then, the sixth valve 27 is opened to introduce the inert gas in the fourth gas supply portion 22 into the second supply line 24 between the third valve 25 and the fourth valve 26 (step S11).

Next, when it is seen that the pressure value of the second pressure gauge 28 reaches, for example, 0.2 MPa or more, the sixth valve 27 is closed (step S12). Accordingly, the second supply line 24 between the third valve 25 and the fourth valve 26 is filled with the inert gas (Ar) at a pressure of 0.2 MPa or more.

Subsequently, if a next workpiece is successively treated (if judged Yes in step S13), the procedure returns to step S1 and the above-described processes are repeated.

That is to say, according to the vacuum treatment apparatus 1A of Embodiment 1, for example, when treatment using the combustion-supporting gas is started in step S8, the second supply line 24 and the common line 32 are filled with the combustion-supporting gas, and the combustion-supporting gas has flown into a position very close to the downstream side of the second valve 16. In this state, even when a leak occurs at the second valve 16, the combustion-supporting gas can be prevented from flowing via the second valve 16 into the supply line on the side of the first gas supply portion 11 filled with the flammable gas, because the supply line between the second valve 16 and the first valve 15 is filled with the inert gas. Moreover, in the line, the gas pressure of the combustion-supporting gas (0.15 MPa) is lower than the gas pressure of the inert gas (0.2 MPa or more), and, thus, the combustion-supporting gas does not flow via the second valve 16 into the supply line on the side of the first gas supply portion 11 although the inert gas may flow via the second valve 16 into the supply line on the side of the vacuum vessel 31. Accordingly, even when a further leak occurs at the first valve 15 in this state, the flammable gas and the combustion-supporting gas are not immediately mixed with each other, and, thus, a safer operation than that of the vacuum treatment apparatus in Conventional Technique 1 above or Patent Literature 1 can be performed.

In this case, during the treatment operation, the control means 40 always monitors the pressure values of the first pressure gauge 18 and the second pressure gauge 28. Then, for example, if the pressure value of the first pressure gauge 18 decreases to reach a predetermined value set in advance (e.g., 0.1 MPa) while the first supply line 14 is not being used (i.e., during treatment using the combustion-supporting gas), the control means 40 determines that a leak has occurred at the second valve 16 (or the first valve 15), and ends the process treatment at that time. In a similar manner, if the pressure value of the second pressure gauge 28 decreases to reach a predetermined value set in advance (e.g., 0.1 MPa) while the second supply line 24 is not being used (i.e., during treatment using the flammable gas), the control means 40 determines that a leak has occurred at the fourth valve 26 (or the third valve 25), and ends the process treatment at that time.

That is to say, according to the vacuum treatment apparatus 1A of Embodiment 1, when one of the gas supply lines is being used, the other gas supply line is filled with an inert gas. Furthermore, the pressures at the supply lines are always monitored using a pressure gauge, and, when a leak occurs at a valve, the process treatment is stopped at that time. Accordingly, a safer operation can be performed.

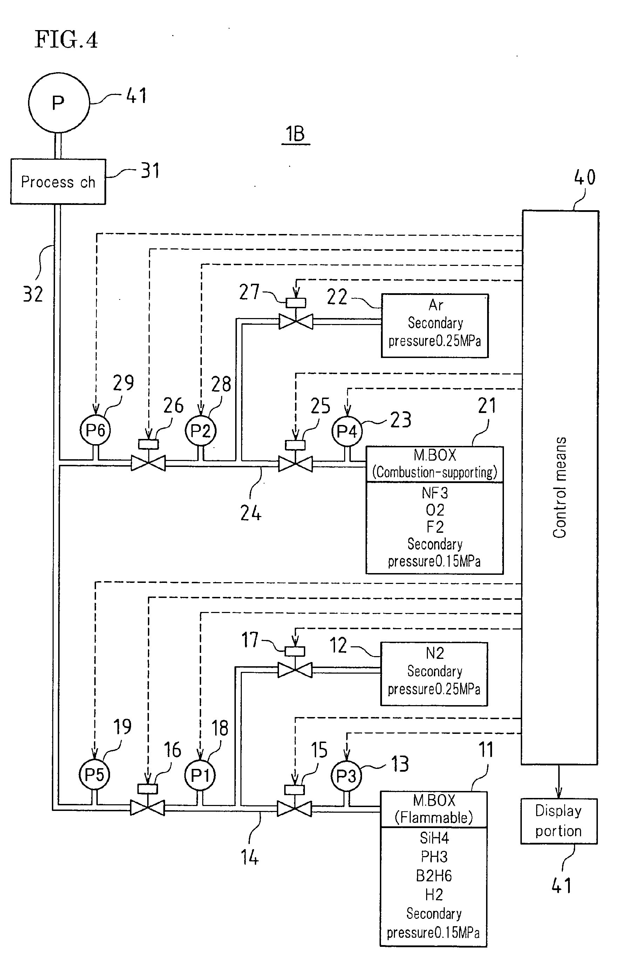

FIG. 4 is a schematic diagram showing a vacuum treatment apparatus according to Embodiment 2 of the present invention. In a vacuum treatment apparatus 1B of Embodiment 2, in addition to the constituent components in the configuration of the vacuum treatment apparatus 1A of Embodiment 1 described above, the first supply line 14 is provided with a third pressure gauge 13 that detects the pressure between the first valve 15 and the first gas supply portion 11 and a fifth pressure gauge 19 that detects the pressure between the second valve 16 and the common line 32, and the second supply line 24 is provided with a fourth pressure gauge 23 that detects the pressure between the third valve 25 and the second gas supply portion 21 and a sixth pressure gauge 29 that detects the pressure between the fourth valve 26 and the common line 32. The other portions of the configuration are the same as those in Embodiment 1, and the vacuum treatment (process treatment) of a workpiece by the vacuum treatment apparatus 1B and the treatment stopping process performed when a leak occurs at any valve are also the same as those in Embodiment 1.

The vacuum treatment apparatus 1B of Embodiment 2 is characterized in that, when a leak occurs, a valve at which the leak has occurred can be easily specified because six pressure gauges are arranged. That is to say, detection signals (pressure values) of the pressure gauges 13, 18, 19, 23, 28, and 29 are input to the control means 40 during vacuum treatment (process treatment) of a workpiece, and the control means 40 specifies a valve at which the leak has occurred based on the detection signals (pressure values) from the pressure gauges 13, 18, 19, 23, 28, and 29.

More specifically, during the treatment operation, the control means 40 always monitors the pressure values of the pressure gauges 13, 18, 19, 23, 28, and 29. Then, for example, while the first supply line 14 is not being used (i.e., during treatment using the combustion-supporting gas); if the pressure value of the first pressure gauge 18 decreases and the pressure value of the third pressure gauge 13 increases, it is determined that a leak has occurred at the first valve 15, and, if the pressure value of the first pressure gauge 18 decreases and the pressure value of the fifth pressure gauge 19 increases, it is determined that a leak has occurred at the second valve 16. Furthermore, for example, while the second supply line 24 is not being used (i.e., during treatment using the flammable gas), if the pressure value of the second pressure gauge 28 decreases and the pressure value of the fourth pressure gauge 23 increases, it is determined that a leak has occurred at the third valve 25, and, if the pressure value of the second pressure gauge 28 decreases and the pressure value of the sixth pressure gauge 29 increases, it is determined that a leak has occurred at the fourth valve 26. In this case, the control means 40 may be configured so as to display the specified valve at which the leak has occurred on a display portion 41 connected thereto. Accordingly, when a leak occurs, a manager of the apparatus can immediately specify a valve at which the leak has occurred, and promptly perform subsequent repair, maintenance, or other operations.

### Reference Signs List

- 1A, 1B: Vacuum treatment apparatus
- 11: First gas supply portion
- 12: Third gas supply portion
- 13: Third pressure gauge (P3)
- 14: First supply line
- 15: First valve
- 16: Second valve
- 17: Fifth valve
- 18: First pressure gauge (P1)
- 19: Fifth pressure gauge (P5)
- 21: Second gas supply portion
- 22: Fourth gas supply portion
- 23: Fourth pressure gauge (P4)
- 24: Second supply line
- 25: Third valve
- 26: Fourth valve
- 27: Sixth valve
- 28: Second pressure gauge (P2)
- 29: Sixth pressure gauge (P6)
- 31: Vacuum vessel
- 32: Common line
- 41: Vacuum discharge pump

## Claims

1. A vacuum treatment apparatus, comprising: a first gas supply portion that is filled with a flammable gas; a second gas supply portion that is filled with a combustion-supporting gas; a vacuum vessel that performs treatment using either the flammable gas or the combustion-supporting gas introduced from a common line; a first supply line that supplies the flammable gas from the first gas supply portion via the common line to the vacuum vessel; a second supply line that supplies the combustion-supporting gas from the second gas supply portion via the common line to the vacuum vessel; a first valve that is provided in the first supply line; a second valve that is provided in the first supply line at a position that is closer to the common line than the first valve is; a third valve that is provided in the second supply line; a fourth valve that is provided in the second supply line at a position that is closer to the common line than the third valve is; and a control means that controls an opening and closing operation of the valves;
wherein a third gas supply portion that supplies an inert gas is connected via a fifth valve to the first supply line between the first valve and the second valve,
a fourth gas supply portion that supplies an inert gas is connected via a sixth valve to the second supply line between the third valve and the fourth valve, and
the control means fills the second supply line between the third valve and the fourth valve with the inert gas by supplying the inert gas from the fourth gas supply portion via the sixth valve before using the first supply line, and fills the first supply line between the first valve and the second valve with the inert gas by supplying the inert gas from the third gas supply portion via the fifth valve before using the second supply line.

2. The vacuum treatment apparatus according to claim 1,
wherein the first supply line is provided with a first pressure detecting means that detects a pressure between the first valve and the second valve,
the second supply line is provided with a second pressure detecting means that detects a pressure between the third valve and the fourth valve,
and
the control means stops vacuum treatment in a case where the pressure detecting means detects a pressure decrease in one of the supply lines while the other supply line is being used.

3. The vacuum treatment apparatus according to claim 2,
wherein the first supply line is provided with a third pressure detecting means that detects a pressure between the first valve and the first gas supply portion,
the second supply line is provided with a fourth pressure detecting means that detects a pressure between the third valve and the second gas supply portion, and
the control means determines that a leak has occurred at the first valve in a case where the first pressure detecting means detects a pressure decrease and the third pressure detecting means detects a pressure increase while the second supply line is being used, and determines that a leak has occurred at the third valve in a case where the second pressure detecting means detects a pressure decrease and the fourth pressure detecting means detects a pressure increase while the first supply line is being used.

4. The vacuum treatment apparatus according to claim 2,
wherein the first supply line is provided with a fifth pressure detecting means that detects a pressure between the second valve and the common line,
the second supply line is provided with a sixth pressure detecting means that detects a pressure between the fourth valve and the common line,
and
the control means determines that a leak has occurred at the second valve in a case where the first pressure detecting means detects a pressure decrease and the fifth pressure detecting means detects a pressure increase while the second supply line is being used, and determines that a leak has occurred at the fourth valve in a case where the second pressure detecting means detects a pressure decrease and the sixth pressure detecting means detects a pressure increase while the first supply line is being used.

5. A gas supply method for a vacuum treatment apparatus including a first gas supply portion that is filled with a flammable gas, a second gas supply portion that is filled with a combustion-supporting gas, a vacuum vessel that performs treatment using either the flammable gas or the combustion-supporting gas introduced from a common line, a first supply line that supplies the flammable gas from the first gas supply portion via the common line to the vacuum vessel, a second supply line that supplies the combustion-supporting gas from the second gas supply portion via the common line to the vacuum vessel, a first valve that is provided in the first supply line, a second valve that is provided in the first supply line at a position that is closer to the common line than the first valve is, a third valve that is provided in the second supply line, a fourth valve that is provided in the second supply line at a position that is closer to the common line than the third valve is, a third gas supply portion that supplies an inert gas via a fifth valve to the first supply line between the first valve and the second valve, and a fourth gas supply portion that supplies an inert gas via a sixth valve to the second supply line between the third valve and the fourth valve, the method comprising the steps of:
when the treatment in the vacuum vessel using the flammable gas ends,
closing the first valve and performing evacuation;
after the evacuation, closing the second valve;
subsequently opening the fifth valve to supply the inert gas from the third gas supply portion to the first supply line between the first valve and the second valve; and
after supplying the inert gas, closing the fifth valve; and
when the treatment in the vacuum vessel using the combustion-supporting gas ends,
closing the third valve and performing evacuation;
after the evacuation, closing the fourth valve;
subsequently opening the sixth valve to supply the inert gas from the fourth gas supply portion to the second supply line between the third valve and the fourth valve; and
after supplying the inert gas, closing the sixth valve.

6. The gas supply method for a vacuum treatment apparatus according to claim 5, further comprising the steps of:
stopping the treatment in the vacuum vessel using the flammable gas in a case where a pressure between the third valve and the fourth valve in the second supply line decreases during the treatment in the vacuum vessel using the flammable gas; and
stopping the treatment in the vacuum vessel using the combustion-supporting gas in a case where a pressure between the first valve and the second valve in the first supply line decreases during the treatment in the vacuum vessel using the combustion-supporting gas.

7. The gas supply method for a vacuum treatment apparatus according to claim 5, further comprising the steps of:
determining that a leak has occurred at the third valve in a case where a pressure between the third valve and the fourth valve in the second supply line decreases and a pressure between the third valve and the second gas supply portion increases during the treatment in the vacuum vessel using the flammable gas; and
determining that a leak has occurred at the first valve in a case where a pressure between the first valve and the second valve in the first supply line decreases and a pressure between the first valve and the first gas supply portion increases during the treatment in the vacuum vessel using the combustion-supporting gas.

8. The gas supply method for a vacuum treatment apparatus according to claim 5, further comprising the steps of:
determining that a leak has occurred at the fourth valve in a case where a pressure between the third valve and the fourth valve in the second supply line decreases and a pressure between the fourth valve and the common line increases during the treatment in the vacuum vessel using the flammable gas; and
determining that a leak has occurred at the second valve in a case where a pressure between the first valve and the second valve in the first supply line decreases and a pressure between the second valve and the common line increases during the treatment in the vacuum vessel using the combustion-supporting gas.
